# EUROPEAN PATENT APPLICATION

(11) **EP 4 622 096 A1**
(43) Date of publication of application: **24.09.2025**
(21) Application number: 23891090.5
(22) Date of filing: 10.07.2023
(51) Int. Cl.: H03D 7/00, H03D 7/12, H03D 7/14

(54) **PASSIVE MIXER CIRCUIT**

(30) Priority: 15.11.2022 JP 2022182378
(71) Applicant: Fujikura Ltd., Tokyo 135-8512 (JP)
(72) Inventor: YOSHIYAMA, Masayuki, Sakura-shi, Chiba 285-8550 (JP)
(74) Representative: Lavoix
(86) International application number: PCT/JP2023/025446
(87) International publication number: WO 2024/105928

(57) **Abstract**

A passive mixer circuit includes a high-frequency terminal, a low-frequency terminal, a main MOSFET to which a local oscillation frequency signal is input, and a bias generation section, in which the bias generation section includes a sub-MOSFET of a same type as the main MOSFET, a voltage follower circuit including an operational amplifier, and a resistance element, a drain and a gate of the sub-MOSFET are shorted and directly or indirectly receive an output from the voltage follower circuit, a reference voltage is input to a non-inverting input terminal of the operational amplifier, a gate bias voltage based on a gate voltage of the sub-MOSFET is supplied to a gate of the main MOSFET, and a source-drain bias voltage based on a source voltage of the sub-MOSFET is supplied to a source or a drain of the main MOSFET.

## Description

### TECHNICAL FIELD

The present invention relates to a passive mixer circuit.

Priority is claimed on Japanese Patent Application No. 2022-182378, filed November 15, 2022, the content of which is incorporated herein by reference.

### BACKGROUND ART

Patent Document 1 discloses a passive mixer circuit that converts a high-frequency signal into a low-frequency signal (baseband signal). In this passive mixer circuit, local oscillation frequency signals are input to gates of MOSFETs M1 and M4. The frequency conversion is performed by switching the MOSFETs M1 and M4 using the local oscillation frequency signals. Such a passive mixer circuit is used, for example, by being incorporated into a high-frequency semiconductor circuit in order to perform the frequency conversion of the high-frequency signal.

### Citation List

### Patent Document

Patent Document 1: United States Patent No. 7,277,682

### SUMMARY OF INVENTION

### Technical Problem

In the configuration of Patent Document 1, in order for the MOSFET, to which the local oscillation frequency signal is input, to function as a switch, it is necessary to set a gate bias voltage and a source-drain bias voltage to optimal values. In general, the gate bias voltage is fixed to a value larger than the source-drain bias voltage by a threshold voltage of the MOSFET. However, in a case in which a temperature change occurs, the threshold voltage of the MOSFET fluctuates, and thus there is a possibility that the linearity of frequency conversion is decreased.

The present invention has been made in consideration of such circumstances, and an object of the present invention is to provide a passive mixer circuit that can suppress a decrease in linearity of frequency conversion due to a temperature change.

### Solution to Problem

In order to achieve the above-described object, Aspect 1 of the present invention provides a passive mixer circuit including: a high-frequency terminal through which a high-frequency signal is input and output; a low-frequency terminal through which a low-frequency signal having a frequency lower than a frequency of the high-frequency signal is input and output; a main MOSFET having a gate to which a local oscillation frequency signal is input; and a bias generation section, in which the bias generation section includes a sub-MOSFET of a same type as the main MOSFET, a voltage follower circuit including an operational amplifier, and a resistance element connected in series with a source of the sub-MOSFET, a drain and a gate of the sub-MOSFET are shorted and directly or indirectly receive an output from the voltage follower circuit, a reference voltage is input to a non-inverting input terminal of the operational amplifier, a gate bias voltage generated based on a gate voltage of the sub-MOSFET is supplied to the gate of the main MOSFET, and a source-drain bias voltage generated based on a source voltage of the sub-MOSFET is supplied to a source or a drain of the main MOSFET.

Aspect 2 of the present invention provides the passive mixer circuit according to Aspect 1, in which the channel lengths of the main MOSFET and the sub-MOSFET are substantially the same as each other.

Aspect 3 of the present invention provides the passive mixer circuit according to Aspect 1 or 2, in which the channel widths of the main MOSFET and the sub-MOSFET are substantially the same as each other.

Aspect 4 of the present invention provides the passive mixer circuit according to any one of Aspects 1 to 3, in which the bias generation section includes an intermediate MOSFET and a current mirror circuit, and the output from the voltage follower circuit is indirectly input to the drain and the gate of the sub-MOSFET via the intermediate MOSFET and the current mirror circuit.

### Advantageous Effects of Invention

According to the above-described aspects of the present invention, it is possible to provide the passive mixer circuit that can suppress the decrease in the linearity of the frequency conversion due to the temperature change.

### BRIEF DESCRIPTION OF DRAWINGS

[FIG. 1] A diagram showing the configuration of a passive mixer circuit according to a first embodiment.
[FIG. 2] A diagram showing a structure of a MOSFET.
[FIG. 3] A diagram showing the configuration of a passive mixer circuit according to a second embodiment.
[FIG. 4] A diagram showing the configuration of a passive mixer circuit according to a modification example of the second embodiment.
[FIG. 5] A diagram showing the configuration of a bias generation section according to a third embodiment.

### DESCRIPTION OF EMBODIMENTS

### (First Embodiment)

Hereinafter, a passive mixer circuit of a first embodiment will be described with reference to the drawings.

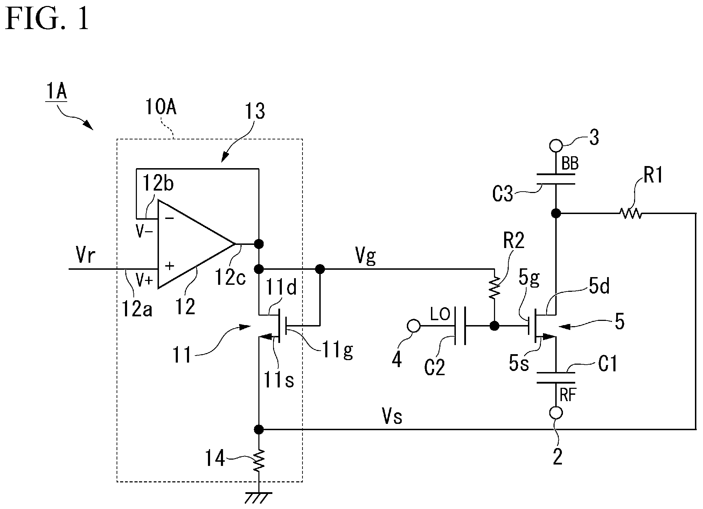

As shown in FIG. 1, a passive mixer circuit 1A includes a high-frequency terminal 2, a low-frequency terminal 3, an LO terminal 4, a main metal-oxide-semiconductor field effect transistor (MOSFET) 5, and a bias generation section 10A. The passive mixer circuit 1A may be configured in, for example, one semiconductor chip. In particular, it is preferable that the main MOSFET 5 and a sub-MOSFET 11 included in the bias generation section 10A are configured in one semiconductor chip. However, some of the components included in the passive mixer circuit 1A may be provided on a different chip (or substrate or the like) from the other components.

A high-frequency signal RF is input and output through (input to and output from) the high-frequency terminal 2.

A low-frequency signal BB is input to and output from the low-frequency terminal 3. The low-frequency signal BB is a signal having a lower frequency than the high-frequency signal RF, and is also called a baseband signal. The passive mixer circuit 1A is configured to perform up-conversion of frequency-converting the low-frequency signal BB into the high-frequency signal RF or down-conversion of frequency-converting the high-frequency signal RF into the low-frequency signal BB.

A local oscillator (LO) (not shown) is connected to the LO terminal 4. A local oscillation frequency signal LO, which is generated by the local oscillator, is input to the LO terminal 4. The frequency of the local oscillation frequency signal LO is higher than the frequency of the low-frequency signal BB. The frequency of the local oscillation frequency signal LO may be lower than the frequency of the high-frequency signal RF or may be higher than the frequency of the high-frequency signal RF.

The main MOSFET 5 includes three terminals corresponding to a gate 5g, a drain 5d, and a source 5s. The gate 5g is connected to the LO terminal 4 via a capacitor C2. The local oscillation frequency signal LO is input to the gate 5g. The source 5s is connected to the high-frequency terminal 2 via a capacitor C1. The drain 5d is connected to the low-frequency terminal 3 via a capacitor C3.

A gate bias voltage Vg, which is generated by the bias generation section 10A, is supplied to the gate 5g of the main MOSFET 5. A source-drain bias voltage Vs, which is generated by the bias generation section 10A, is supplied to the drain 5d or the source 5s of the main MOSFET 5. In the present embodiment, the gate bias voltage Vg and a reference voltage Vr (details will be described later) are substantially the same each other.

The bias generation section 10A includes a sub-MOSFET 11, a voltage follower circuit 13 including an operational amplifier 12, and a resistance element 14. The operational amplifier 12 includes a non-inverting input terminal 12a, an inverting input terminal 12b, and an output terminal 12c. The output terminal 12c is shorted to the inverting input terminal 12b, thereby forming the voltage follower circuit 13. The reference voltage Vr is supplied to the non-inverting input terminal 12a from the outside of the bias generation section 10A.

The sub-MOSFET 11 includes a gate 11g, a drain 11d, and a source 11s. The sub-MOSFET 11 is diode-connected. That is, the drain 11d and the gate 11g are shorted. Therefore, in the sub-MOSFET 11, a drain-source voltage and a gate-source voltage are the same each other. The output terminal 12c of the operational amplifier 12 is connected to the gate 11g. As a result, the output from the voltage follower circuit 13 is supplied to the gate 11g and the drain 11d.

The source 11s and the resistance element 14 are connected in series with each other. The resistance element 14 has a first terminal connected to the source 11s, and a second terminal connected to a ground. A portion between the source 11s and the resistance element 14 is connected to the drain 5d of the main MOSFET 5 via a resistor R1. The gate bias voltage Vg based on a voltage (gate voltage) of the gate 11g is supplied to the gate 5g of the main MOSFET 5, and the source-drain bias voltage Vs based on a voltage (source voltage) of the source 11s is supplied to the drain 5d of the main MOSFET 5. The resistance value of the resistance element 14 is an element that determines a current flowing through the sub-MOSFET 11. The resistance value of the resistance element 14 is determined in accordance with the environmental temperature or the like in which the passive mixer circuit 1A is used.

The capacitors C1 to C3 shown in FIG. 1 have a function of removing an unnecessary direct current component (DC component). The capacitance of the capacitors C1 to C3 is set for each signal path, for impedance matching. An inductor (coil) (not shown) may be disposed in series or in parallel with the capacitors C1 to C3, for impedance matching. The resistors R1 and R2 have a function of removing an unnecessary alternating current component (AC component). The resistance values of the resistors R1 and R2 are set in accordance with a frequency of a signal. The resistance values of the resistors R1 and R2 are, for example, several hundred Ω to several kilo Ω.

Here, the main MOSFET 5 and the sub-MOSFET 11 are the same type. For example, in a case in which the main MOSFET 5 is a p-type, the sub-MOSFET 11 is also a p-type. In addition, in a case in which the main MOSFET 5 is n-type, the sub-MOSFET 11 is also n-type.

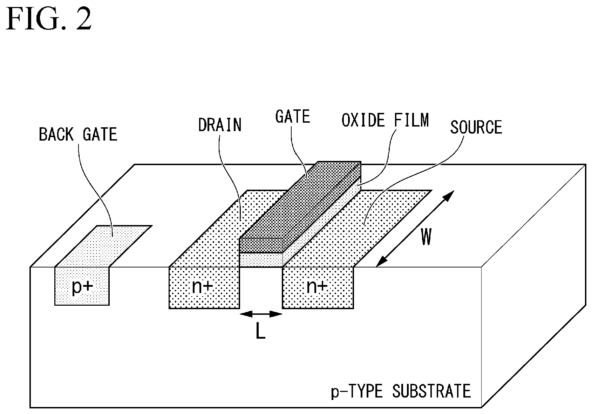

FIG. 2 shows a general structure of an n-type MOSFET. In FIG. 2, W is a so-called channel width, and L is a so-called channel length. It is preferable that the channel lengths L of the main MOSFET 5 and the sub-MOSFET 11 are substantially the same as each other. Further, it is preferable that the channel widths W of the main MOSFET 5 and the sub-MOSFET 11 are substantially the same as each other. In the present specification, the term "substantially the same" means that the two elements can be considered to be the same in a case in which a manufacturing error is removed.

In FIG. 2, the n-type MOSFET is described as an example, but, in a case in which the main MOSFET 5 and the sub-MOSFET 11 are the p-type, it is also preferable that the dimensions L and W are substantially the same as each other.

Next, an operation of the passive mixer circuit 1A configured as described above will be described.

As shown in FIG. 1, the sub-MOSFET 11 is diode-connected. Therefore, the gate-source voltage of the sub-MOSFET 11 is a value close to a threshold voltage of the sub-MOSFET 11. Here, the threshold voltage of the sub-MOSFET 11 fluctuates due to a temperature change. In a case in which the threshold voltage of the sub-MOSFET 11 fluctuates, the gate-source voltage of the sub-MOSFET 11 also fluctuates to follow the fluctuation in the threshold voltage. Therefore, the gate bias voltage Vg is generated based on the gate voltage of the sub-MOSFET 11, and the source-drain bias voltage Vs is generated based on the source voltage of the sub-MOSFET 11. Then, the difference between the gate bias voltage Vg and the source-drain bias voltage Vs also fluctuates to follow the threshold voltage of the sub-MOSFET 11.

The gate bias voltage Vg is supplied to the gate 5g of the main MOSFET 5. The source-drain bias voltage Vs is supplied to the drain 5d of the main MOSFET. A difference between the gate bias voltage Vg and the source-drain bias voltage Vs, which are supplied to the main MOSFET 5, acts as a bias in a case in which the main MOSFET 5 functions as a switch. The fluctuation in the threshold voltage generated in the sub-MOSFET 11 is reflected in the magnitude of the bias.

Since the main MOSFET 5 and the sub-MOSFET 11 have the same structure, it is considered that the threshold voltages of the main MOSFET 5 and the sub-MOSFET 11 are the same as each other. Therefore, in a case in which the threshold voltage of the main MOSFET 5 fluctuates, the bias voltage following the fluctuation is applied to the main MOSFET 5, and thus the fluctuation in the threshold voltage can be canceled. As described above, by canceling the fluctuation in the threshold voltage of the main MOSFET 5, it is possible to ensure the linearity of the frequency conversion in the passive mixer circuit 1A even in a case in which the environmental temperature changes.

In particular, in a case in which the main MOSFET 5 and the sub-MOSFET 11 are provided in the same chip, the temperature changes occurring in the main MOSFET 5 and the sub-MOSFET 11 are also the same as each other. Therefore, it is possible to more reliably obtain the above-described effect. Further, in a case in which the structures of the main MOSFET 5 and the sub-MOSFET 11 are the same (the channel lengths L and the channel widths W are substantially the same), the fluctuations in the threshold voltage due to the temperature change are more matched. Therefore, it is possible to more reliably obtain the above-described effect.

However, in a case in which the types of the main MOSFET 5 and the sub-MOSFET 11 are at least the same, the tendencies of the fluctuation in the threshold voltage to be generated in the main MOSFET 5 and the sub-MOSFET 11 match each other. In addition, even in a case in which the main MOSFET 5 and the sub-MOSFET 11 are not provided in the same chip, the effect of canceling the fluctuation in the threshold voltage can be obtained in an environment in which the same temperature change occurs. Therefore, it is not an essential condition that the main MOSFET 5 and the sub-MOSFET 11 are provided in the same chip and have the same structure.

In addition, in a case in which the main MOSFET 5 and the sub-MOSFET 11 are formed through the same manufacturing process, there is a high probability that the magnitude of a deviation of the threshold voltage from a design value due to a manufacturing variation is the same between the main MOSFET 5 and the sub-MOSFET 11. With the passive mixer circuit 1A according to the present embodiment, even in a case in which the threshold voltage of the main MOSFET 5 deviates from the design value due to manufacturing variation, the deviation can be canceled as long as the main MOSFET 5 and the sub-MOSFET 11 are formed through the same manufacturing process. The mechanism for canceling the deviation is the same as in a case in which the threshold voltage changes due to the temperature change. Therefore, it is possible to suppress the manufacturing variation in frequency conversion characteristics of the passive mixer circuit 1A.

In the example of FIG. 1, the source-drain bias voltage Vs is supplied to the drain 5d of the main MOSFET 5. However, even in a case in which the source-drain bias voltage Vs is supplied to the source 5s, the same action and effect can be obtained as long as the fluctuation in the threshold voltage of the sub-MOSFET 11 is reflected in the difference between the gate bias voltage Vg and the source-drain bias voltage Vs. Therefore, the source-drain bias voltage Vs need only be supplied to the drain 5d or the source 5s.

As described above, the passive mixer circuit 1A according to the present embodiment includes the high-frequency terminal 2 through which the high-frequency signal RF is input and output, the low-frequency terminal 3 through which the low-frequency signal BB having a frequency lower than the frequency of the high-frequency signal RF is input and output, the main MOSFET 5 having the gate 5g through which the local oscillation frequency signal LO is input, and the bias generation section 10A. The bias generation section 10A includes the sub-MOSFET 11 of the same type as the main MOSFET 5, the voltage follower circuit 13 including the operational amplifier 12, and the resistance element 14 connected in series with the source 11s of the sub-MOSFET 11. The drain 11d and the gate 11g of the sub-MOSFET 11 are shorted, and directly receive the output from the voltage follower circuit 13. The reference voltage Vr is input to the non-inverting input terminal 12a of the operational amplifier 12. The gate bias voltage Vg, which is generated based on the voltage of the gate 11g of the sub-MOSFET 11, is supplied to the gate 5g of the main MOSFET 5. The source-drain bias voltage Vs, which is generated based on the voltage of the source 11s of the sub-MOSFET 11, is supplied to the source 5s or the drain 5d of the main MOSFET 5. With the passive mixer circuit 1A having such a configuration, it is possible to suppress the decrease in the linearity of the frequency conversion due to the temperature change. In addition, since the power consumption in the operational amplifier 12 is small, an increase amount of the power consumption for generating the gate bias voltage Vg and the source-drain bias voltage Vs is small. In addition, the voltage of the first terminal of the resistance element 14 (voltage between the resistance element 14 and the source 11s) is mainly determined by the characteristics of the diode-connected sub-MOSFET 11. Therefore, even in a case in which the resistance value of the resistance element 14 fluctuates due to a factor such as the temperature change, the influence on the linearity of the passive mixer circuit 1A is small.

The channel lengths L of the main MOSFET 5 and the sub-MOSFET 11 may be substantially the same as each other. Further, the channel widths W of the main MOSFET 5 and the sub-MOSFET 11 may be substantially the same as each other. In these cases, the magnitude of the fluctuations in the threshold voltage is more matched between the main MOSFET 5 and the sub-MOSFET 11. Therefore, it is possible to more effectively suppress the decrease in the linearity of the frequency conversion due to the temperature change.

### (Second Embodiment)

Next, a second embodiment according to the present invention will be described, but a basic configuration is the same as the basic configuration of the first embodiment. Therefore, the same configuration is denoted by the same reference numeral, the description thereof will be omitted, and only a difference will be described.

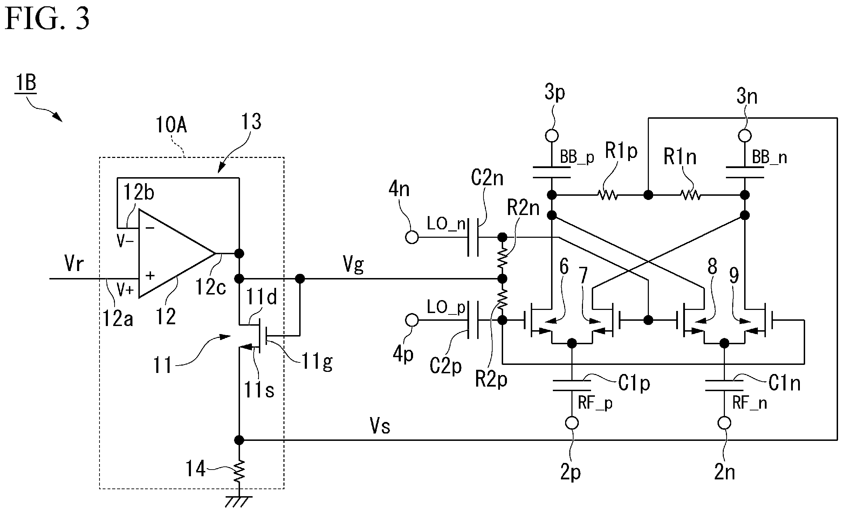

In the present embodiment, an example will be described in which the passive mixer circuit 1A described in the first embodiment is applied to a double-balanced mixer. FIG. 3 shows a passive mixer circuit 1B that can perform down-conversion.

As shown in FIG. 3, the passive mixer circuit 1B according to the present embodiment includes the same bias generation section 10A as in the first embodiment. The passive mixer circuit 1B includes a pair of high-frequency terminals 2p and 2n, a pair of low-frequency terminals 3p and 3n, a pair of LO terminals 4p and 4n, and four main MOSFETs 6 to 9. The pair of high-frequency terminals 2p and 2n corresponds to the high-frequency terminal 2 according to the first embodiment. The pair of low-frequency terminals 3p and 3n corresponds to the low-frequency terminal 3 according to the first embodiment. The pair of LO terminals 4p and 4n corresponds to the LO terminal 4 according to the first embodiment. The four main MOSFETs 6 to 9 correspond to the main MOSFET 5 according to the first embodiment.

A high-frequency signal RF_p is input to and output from the high-frequency terminal 2p, and a high-frequency signal RF_n is input to and output from the high-frequency terminal 2n. A low-frequency signal BB_p is input to and output from the low-frequency terminal 3p, and a low-frequency signal BB_n is input to and output from the low-frequency terminal 3n. A local oscillation frequency signal LO_p is input to the LO terminal 4p, and a local oscillation frequency signal LO_n is input to the LO terminal 4n. Here, the local oscillation frequency signals LO_p and LO_n are a pair of signals having the same frequency and having a phase difference of 180° therebetween. The first local oscillation frequency signal LO_p is input to each gates of the main MOSFETs 6 and 9 via a capacitor C2p. The second local oscillation frequency signal LO_n is input to each gates of the main MOSFETs 7 and 8 via a capacitor C2n.

The gate bias voltage Vg, which is generated by the bias generation section 10A, is supplied to each gates of the main MOSFETs 6 and 9 via a resistor R2p. In addition, the gate bias voltage Vg, which is generated by the bias generation section 10A, is supplied to each gates of the main MOSFETs 7 and 8 via a resistor R2n. The source-drain bias voltage Vs, which is generated by the bias generation section 10A, is supplied to each drains of the main MOSFETs 6 to 9 via resistors R1p and R1n.

In the passive mixer circuit 1B, the high-frequency signals RF_p and RF_n are a pair of signals having the same frequency and having a phase difference of 180° therebetween. The pair of high-frequency signals RF_p and RF_n are subjected to the down-conversion by the local oscillation frequency signals LO_p and LO_n to generate a pair of low-frequency signals BB_p and BB_n having a phase difference of 180° therebetween.

The main MOSFETs 6 to 9 and the sub-MOSFET 11 are the same type. For example, in a case in which the main MOSFETs 6 to 9 are the p-type, the sub-MOSFET 11 is also the p-type. In addition, in a case in which the main MOSFETs 6 to 9 are the n-type, the sub-MOSFET 11 is also the n-type. In the present embodiment, it is preferable that the channel lengths L of the main MOSFETs 6 to 9 and the sub-MOSFET 11 have substantially the same as each other. Further, it is preferable that the channel widths W of the main MOSFETs 6 to 9 and the sub-MOSFET 11 are substantially the same as each other.

The passive mixer circuit 1B can also perform the up-conversion. In a case of the up-conversion, the terminals 2p and 2n in FIG. 3 function as the low-frequency terminals, and receive the low-frequency signals. In this case, the terminals 3p and 3n in FIG. 3 function as the high-frequency terminals, and output the high-frequency signals.

As described above, the passive mixer circuit 1B according to the present embodiment includes the high-frequency terminals 2p and 2n through which the high-frequency signals RF_p and RF_n are input and output, the low-frequency terminals 3p and 3n through which the low-frequency signals BB_p and BB_n having frequencies lower than the frequencies of the high-frequency signals RF_p and RF _n are input and output, the main MOSFETs 6 to 9 having the gates through which the local oscillation frequency signals LO_p and LO_n are input, and the bias generation section 10A. The bias generation section 10A includes the sub-MOSFET 11 of the same type as the main MOSFETs 6 to 9, the voltage follower circuit 13 including the operational amplifier 12, and the resistance element 14 connected in series with the source 11s of the sub-MOSFET 11. The drain 11d and the gate 11g of the sub-MOSFET 11 are shorted, and directly receive the output from the voltage follower circuit 13. The reference voltage Vr is input to the non-inverting input terminal 12a of the operational amplifier 12. The gate bias voltage Vg, which is generated based on the voltage of the gate 11g of the sub-MOSFET 11, is supplied to the gates of the main MOSFETs 6 to 9. The source-drain bias voltage Vs, which is generated based on the voltage of the source 11s of the sub-MOSFET 11, is supplied to the source or the drain of the main MOSFETs 6 to 9. As in the first embodiment, with the passive mixer circuit 1B having such a configuration, it is possible to suppress the decrease in the linearity of the frequency conversion due to the temperature change.

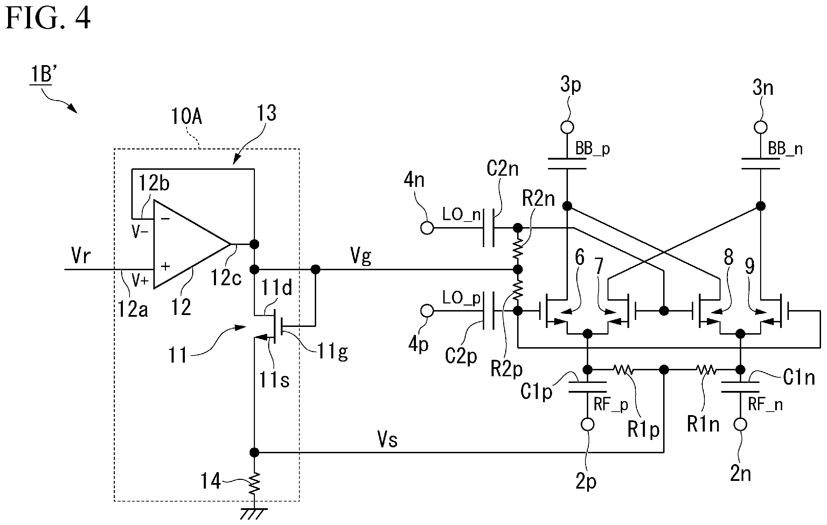

As a modification example of the present embodiment, a passive mixer circuit 1B' that can perform the up-conversion is shown in FIG. 4. As shown in FIG. 4, the passive mixer circuit 1B' is different from the passive mixer circuit 1B that performs the down-conversion in that the supply destination of the source-drain bias voltage Vs and the positions of the resistors R1p and R1n are different. Specifically, the source-drain bias voltage Vs is supplied to the sources of the main MOSFETs 6 to 9 via the resistors R1p and R1n.

In the passive mixer circuit 1B', the low-frequency signals BB_p and BB_n are a pair of signals having the same frequency and having a phase difference of 180° therebetween. The pair of low-frequency signals BB_p and BB_n is subjected to the up-conversion by the local oscillation frequency signals LO_p and LO_n, to generate the pair of high-frequency signals RF_p and RF_n having a phase difference of 180° therebetween.

In the passive mixer circuit 1B', it is also possible to suppress the decrease in the linearity of the frequency conversion due to the temperature change.

The passive mixer circuit 1B' can also perform the down-conversion. In a case of the down-conversion, the terminals 2p and 2n in FIG. 4 function as the high-frequency terminals, and receive the high-frequency signals. In this case, the terminals 3p and 3n in FIG. 4 function as the low-frequency terminals, and outputs the low-frequency signals.

### (Third Embodiment)

Next, a third embodiment according to the present invention will be described, in which the same configuration as in the first and second embodiments is denoted by the same reference numeral, the description thereof will be omitted, and only a difference will be described.

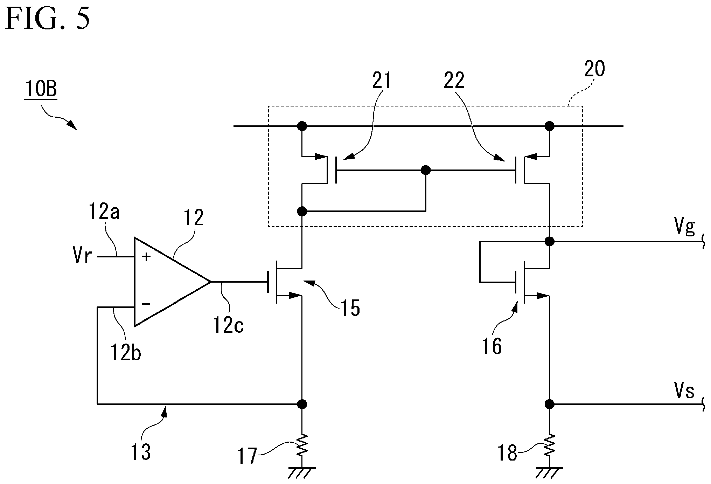

In the present embodiment, a modification example of the bias generation section will be described. In the bias generation section 10A described in the first embodiment, the reference voltage Vr and the gate bias voltage Vg are substantially the same each other. In a bias generation section 10B according to the present embodiment shown in FIG. 5, the reference voltage Vr and the source-drain bias voltage Vs are substantially the same each other.

As shown in FIG. 5, the bias generation section 10B includes the voltage follower circuit 13 including the operational amplifier 12, an intermediate MOSFET 15, a sub-MOSFET 16, a current mirror circuit 20, and resistance elements 17 and 18. The sub-MOSFET 16 corresponds to the sub-MOSFET 11 according to the first embodiment. However, the output from the voltage follower circuit 13 is input to a gate of the intermediate MOSFET 15, and the intermediate MOSFET 15 is not diode-connected. On the other hand, the output from the voltage follower circuit 13 is indirectly input to the sub-MOSFET 16 via the current mirror circuit 20 and the like.

The resistance element 18 corresponds to the resistance element 14 according to the first embodiment. The resistance values of the resistance elements 17 and 18 are the same each other. The resistance element 17 is connected in series with a source of the intermediate MOSFET 15, and the resistance element 18 is connected in series with a source of the sub-MOSFET 16. The sub-MOSFET 16 is diode-connected.

The current mirror circuit 20 includes a first MOSFET 21 and a second MOSFET 22. Both the first MOSFET 21 and the second MOSFET 22 are the p-type. The first MOSFET 21 is diode-connected. A drain of the first MOSFET 21 is connected to a drain of the intermediate MOSFET 15, and a drain of the second MOSFET 22 is connected to a drain of the sub-MOSFET 16. A gate of the first MOSFET 21 is connected to a gate of the second MOSFET 22. A common voltage source is connected to a source of the first MOSFET 21 and a source of the second MOSFET 22.

It is preferable that the intermediate MOSFET 15 and the sub-MOSFET 16 have the same type and structure (channel length L and channel width W) as each other. In the bias generation section 10B according to the present embodiment, the gate bias voltage Vg is generated based on the gate voltage of the sub-MOSFET 16, and the source-drain bias voltage Vs is generated based on the source voltage of the sub-MOSFET 16. The supply destinations of the gate bias voltage Vg and the source-drain bias voltage Vs are the same as the supply destinations in the description of the first and second embodiments, and thus the description will be omitted. The intermediate MOSFET 15 and the sub-MOSFET 16 are the same type as the main MOSFET (not shown in FIG. 5).

Subsequently, the operation of the bias generation section 10B according to the present embodiment will be described mainly with the difference from the first embodiment. The reference voltage Vr, which is input to the operational amplifier 12, is converted into a current signal by the intermediate MOSFET 15 and the first MOSFET 21. The first MOSFET 21 and the second MOSFET 22 constitute the current mirror circuit 20. Therefore, the current signal flowing through a path including the first MOSFET 21, the intermediate MOSFET 15, and the resistance element 17 is the same as the current signal flowing through a path including the second MOSFET 22, the sub-MOSFET 16, and the resistance element 18. By selecting each values of the channel widths W/channel lengths L of the first MOSFET 21 and the second MOSFET 22 and the resistance values of the resistance element 17 and the resistance element 18 to be the same, the source voltage of the sub-MOSFET 16 is a value equal to the source voltage of the intermediate MOSFET 15 and is also equal to the reference voltage Vr.

In the current mirror circuit 20, the current signal can be copied as it is, and can also be copied by amplifying or attenuating the current signal.

In a case in which the current signal is copied as it is, the value of the channel width W/channel length L of the first MOSFET 21 and the value of the channel width W/channel length L of the second MOSFET 22 need only be made the same each other. In a case in which the current signal is copied by amplifying or attenuating the current signal, the value of the channel width W/channel length L of the first MOSFET 21 and the value of the channel width W/channel length L of the second MOSFET 22 need only be made different from each other. By using this characteristics, it is possible to adjust the magnitude of the gate bias voltage Vg and the source-drain bias voltage Vs.

As described above, the bias generation section 10B according to the present embodiment includes the sub-MOSFET 16 of the same type as the main MOSFET (not shown in FIG. 5), the voltage follower circuit 13 including the operational amplifier 12, and the resistance element 18 connected in series with the source of the sub-MOSFET 16. The drain and the gate of the sub-MOSFET 16 are shorted, and the output from the voltage follower circuit 13 is indirectly input to the gate of the sub-MOSFET 16. The reference voltage Vr is input to the non-inverting input terminal 12a of the operational amplifier 12, the gate bias voltage Vg, which is generated based on the gate voltage of the sub-MOSFET 16, is supplied to a gate of the main MOSFET (not shown in FIG. 5), and the source-drain bias voltage Vs, which is generated based on the source voltage of the sub-MOSFET 16, is supplied to the source or the drain of the main MOSFET (not shown in FIG. 5).

Furthermore, the bias generation section 10B according to the present embodiment includes the intermediate MOSFET 15 and the current mirror circuit 20, and the output from the voltage follower circuit 13 is indirectly input to the drain and the gate of the sub-MOSFET 16 via the intermediate MOSFET 15 and the current mirror circuit 20.

Even in a case in which the bias generation section 10B according to the present embodiment is used, the same operation and effect as the operation and effect of the first and second embodiments can be obtained.

The technical scope of the present invention is not limited to the above-described embodiments, and various changes can be made within the scope described in CLAIMS.

For example, components that are not shown in FIGS. 1, 3, and 4 may be added to each circuit. Alternatively, some of the components shown in the drawings may be omitted.

In addition, the components in the above-described embodiments may be replaced with well-known components as appropriate, and the above-described embodiments and modification examples may be combined as appropriate within the scope described in

### CLAIMS.

For example, in the passive mixer circuits 1A, 1B, and 1B' shown in FIGS. 1, 3, and 4, the bias generation section 10A may be replaced with the bias generation section 10B according to the third embodiment.

### REFERENCE SIGNS LIST

1A, 1B, 1B' Passive mixer circuit
2, 2p, 2n High-frequency terminal
3, 3p, 3n Low-frequency terminal
5 to 9 Main MOSFET
5d Drain
5g Gate
5s Source
10A, 10B Bias generation section
11, 16 Sub-MOSFET
11d Drain
11g Gate
11s Source
12 Operational amplifier
12a Non-inverting input terminal
12b Inverting input terminal
13 Voltage follower circuit
14, 17, 18 Resistance element
15 Intermediate MOSFET
20 Current mirror circuit
BB, BB_n, BB_p Low-frequency signal
L Channel length
LO, LO_n, LO_p Local oscillation frequency signal
RF, RF_n, RF_p High-frequency signal
W Channel width

## Claims

1. A passive mixer circuit comprising:
a high-frequency terminal through which a high-frequency signal is input and output;
a low-frequency terminal through which a low-frequency signal having a frequency lower than a frequency of the high-frequency signal is input and output;
a main MOSFET having a gate to which a local oscillation frequency signal is input; and
a bias generation section,
wherein the bias generation section includes
a sub-MOSFET of a same type as the main MOSFET,
a voltage follower circuit including an operational amplifier, and
a resistance element connected in series with a source of the sub-MOSFET,
a drain and a gate of the sub-MOSFET are shorted and directly or indirectly receive an output from the voltage follower circuit,
a reference voltage is input to a non-inverting input terminal of the operational amplifier,
a gate bias voltage generated based on a gate voltage of the sub-MOSFET is supplied to the gate of the main MOSFET, and
a source-drain bias voltage generated based on a source voltage of the sub-MOSFET is supplied to a source or a drain of the main MOSFET.

2. The passive mixer circuit according to Claim 1,
wherein channel lengths of the main MOSFET and the sub-MOSFET are substantially the same as each other.

3. The passive mixer circuit according to Claim 2,
wherein channel widths of the main MOSFET and the sub-MOSFET are substantially the same as each other.

4. The passive mixer circuit according to any one of Claims 1 to 3,
wherein the bias generation section includes an intermediate MOSFET and a current mirror circuit, and
the output from the voltage follower circuit is indirectly input to the drain and the gate of the sub-MOSFET via the intermediate MOSFET and the current mirror circuit.
